# EUROPEAN PATENT APPLICATION

(11) **EP 0 540 105 A2**
(43) Date of publication of application: **05.05.1993**
(21) Application number: 92203270.1
(22) Date of filing: 23.10.1992
(51) Int. Cl.: G11C 27/04

(54) **Sampling device for sampling analog signals and digital measuring instrument provided with such a sampling device**

(30) Priority: 31.10.1991 EP 91202823
(71) Applicant: FLUKE CORPORATION, Everett Washington 98203 (US)
(72) Inventor: Noordeloos, Jacob Hendrik, NL-5656 AA Eindhoven (NL); Rensink, Anton Hendrik, NL-5656 AA Eindhoven (NL); Sankaranarayanan, Lakshmi Narayanan, NL-5656 AA Eindhoven (NL)
(74) Representative: Burke, Steven David

(57) **Abstract**

A sampling device (12) for a digital measuring instrument (1) is provided, which device (12) operates on the basis of time conversion. Compared with known sampling devices with time conversion based on CCD technology, the sampling device according to the invention comprises a retiming switch (d1) for retiming analog signals followed by a charge demultiplexing circuit (dmx) which operates in the charge domain. The charge demultiplexing circuit (dmx) is followed by a CCD array (pch0 to pch7) for storage of charge packages of the signal to be converted. The CCD structure, which is filled with charge packages at high speed, is read out at a much lower speed. The CCD structure according to the invention is optimally utilized through a suitable choice of control signals and is easy to control. Furthermore, less high requirements are set for the CCD drivers ad the peripheral clock system.

## Description

The invention relates to a sampling device for sampling analog signals comprising a input for receiving a analog signal, a system of at least two parallel charge-coupled delay lines coupled to the input for storage of signal samples of the analog signal, a output circuit coupled to the system of parallel delay lines for the readout of the signal samples, and control means for controlling charge transport through the system, the signal samples being stored in the form of charge packets, while the storage of the signal samples takes place at a substantially higher speed than the readout thereof.

The invention further relates to a digital measuring instrument provided with such a sampling device.

Such a sampling device ad such a measuring instrument, such as a digital oscilloscope, a transient analyser, a waveform analyser, and other measuring instruments which comprise a sampling device with variable sampling speed, are used for converting analog signals supplied to the measuring instrument into digital values for further processing. In the case of very high sampling speeds, analog signal samples are first stored at high speed in the form of charge packages in a charge-coupled delay line, which is then read out at a lower speed by a analog-to-digital converter. Such a sampling device is of the FISO type: Fast In/Slow Out.

Such a sampling device is known from US Patent 4,725,748. The sampling device described therein comprises two so-called serial-parallel-serial structures of charge-coupled delay lines coupled to the input of the sampling device. In this case, signal samples of the analog signal at the input of the sampling device are first shifted into a serial input section at a comparatively high speed, then shifted synchronously into a parallel storage section, and then supplied at a comparatively low speed to an analog-to-digital converter through a serial output section. In such a sampling device, high requirements are set for the charge transport control system in the case of comparatively high sampling frequencies of the analog signal. The charge transport read/write control logic and drivers, which should in fact be very fast for this, are then expensive. Indeed, the entire peripheral clock system of the sampling device must be very fast, which renders it expensive, quite apart from problems in realising it. To achieve a very high sampling speed, the serial input section must also operate at a very high clock speed. If, for example, a sampling frequency of 1 Gs/sec (1 Giga samples per second) is required, the peripheral clock frequency is 1 GHz, which leads to a - commercially unattractive - expensive clock system.

The invention has for its object to provide a sampling device of the kind mentioned in the opening paragraph which is not encumbered by such drawbacks.

An embodiment of a sampling device according to the invention is characterized in that the parallel delay lines are coupled to one another at their input sides through a charge demultiplexer, and in that time-shifted replicas of the analog signal are offered at input sections of the parallel delay lines through a signal demultiplexer. The use of the charge demultiplexer and of the signal demultiplexer renders a serial input section redundant, while less high requirements are imposed on the peripheral clock system. A very simple and flexible structure for a fast sampling device is obtained through the use of a charge demultiplexer. With a signal demultiplexer having eight outputs, a reduction in a clock frequency by a factor eight relative to a serial-parallel-serial architecture is achieved for the highest clock frequency, so that such a clock system is easy to realise.

An embodiment of a sampling device according to the invention is characterized in that the signal demultiplexer is a branched-off analog delay line and signal sampling takes place in the input sections of the parallel delay lines. A very simple, compact, and comparatively inexpensive front-end system is obtained by this which can operate at a single frequency.

Another embodiment of a sampling device according to the invention is characterized in that the signal demultiplexer is a network of current switches in which time-shifted signal samples of the analog signal are formed which are supplied to the charge demultiplexer through delay lines which are coupled to outputs of the network and which have different delays. Since signal sampling takes place in the network of current switches, this embodiment is less sensitive to deviations in the transmission characteristics of the delay lines. An accurate sampling is obtained which operates at a single frequency.

To achieve that the memory of the system is optimally utilized at various sampling speeds, a further modification of the sampling device according to the invention is characterized in that all input sections are enabled at a maximum sampling speed which can be selected, and the charge packets are clocked into the parallel delay lines synchronously after routing by the charge demultiplexer, and in that input sections are disabled in the case of lower selected sampling speeds and the routing of the charge packets by the charge demultiplexer is adapted in such a way that a equally optimum situation is obtained as with the maximum sampling speed. Apart from the fact that the sampling device is optimally utilized, the transparent structure also renders possible a simple adaptation to various sampling speeds.

A digital measuring instrument according to the invention which comprises a direct sampling circuit ad is provided with a sampling circuit according to the invention is characterized in that the measuring instrument comprises further control means which control the sampling device comprising the system of parallel delay lines for sampling the analog signal in the case of a comparatively high sampling speed, and which control the direct sampling circuit in the case of a comparatively low sampling speed. As a result, sampling may take place in conventional manner in the case of a comparatively low sampling speed.

The invention will be explained in more detail with reference to a drawing in which
Fig. 1 is a block diagram of a digital measuring instrument according to the invention,
Fig. 2 shows a sampling device according to the invention suitable for use in a digital measuring instrument,
Fig. 3 shows a more detailed picture of a sampling device according to the invention,
Figs. 4A, 4B and 4C show various clock signals in a sampling device according to the invention,
Fig. 5A diagrammatically shows an alternative embodiment of a portion of a sampling device according to the invention, and
Fig. 5B shows a signal demultiplexer in more detail.

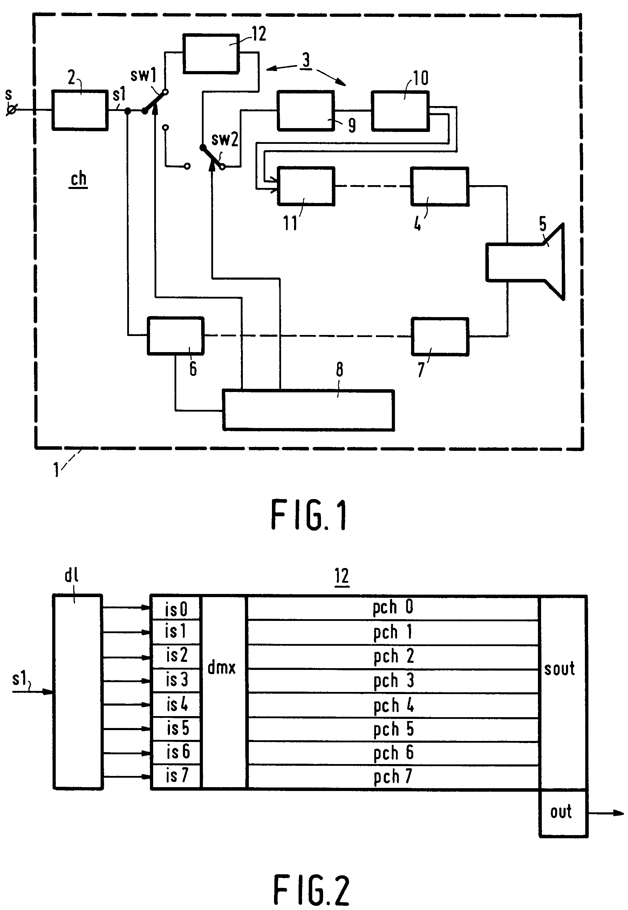

Fig. 1 shows a strongly simplified block diagram of a oscilloscope as a digital measuring instrument 1, comprising a channel ch for the supply of an analog signal s to be measured. The signal s may be a periodic signal. The channel ch comprises an input amplifier 2 followed by a digitizer device 3 for digitizing the analog signal s. The digitizer device 3 is followed by further usual circuits, among which at the end a vertical amplifier 4 whose output is connected to display means 5, such as a cathode ray tube or a LCD screen. In the case of a cathode ray tube, the vertical amplifier controls the vertical deflection of an electron beam. The digital measuring instrument 1 further comprises a trigger device which is coupled to the channel ch and which has a time base circuit 6 which periodically generates a trigger signal for starting the time base in the case in which periodic signals are offered as the signals to be processed. The trigger device with time base circuit 6 is coupled to a horizontal amplifier 7 whose output signal serves to control the horizontal deflection of the electron beam. The digital measuring instrument 1 further comprises digital control means 8 which comprise one or several microprocessors ad memories, as is usual, for controlling various functions of the digital measuring instrument 1, among them the control of the digitizer device 3. The digitizer device 3 comprises a conversion portion for direct analog-to-digital conversion of the analog signal s, comprising in that order a sample-and-hold circuit 9, a analog-to-digital converter 10, and a digital memory 11, and a conversion portion 12 operating at a comparatively high speed for time conversion of the analog signal. Depending on the time base setting of the measuring instrument, the signal is either directly supplied to the conversion portion for direct analog-to-digital conversion, or supplied to this conversion portion *via* the time conversion portion 12. The control means 8 for this purpose control electronic switches sw1 and sw2. The conversion portion 12 for time conversion of the analog signal s may be designed according to usual CCD technology, such as P²CCD. In an analog CCD memory, or charge-coupled delay line, charge packages can be stored of which the quantity of charge is a measure for the signal amplitude of a signal sample of the analog signal s. The CCD memory can be regarded as a analog shift register for charge packets. For a more detailed description of P²CCD, the reader is referred to a article "P²CCD in 60 MHz Oscilloscope with Digital Image Storage" by H. Dollekamp et al., Philips Technical Review, vol. 40, no. 2/3, 1982, pp. 55-68, and further to US Patent 4,725,748. The oscilloscope shown as the digital measuring instrument 1 only serves to illustrate the invention. The invention is not limited to oscilloscopes but can be applied to other measuring instruments as well.

Fig. 2 shows a sampling device 12 in which time conversion takes place and which is suitable for use in a digital measuring instrument 1 according to the invention. The sampling device 12, to which the pre-amplified analog signal s1 is supplied, comprises a number of parallel charge-coupled delay lines pch0 to pch7 whose outputs are coupled to an analog serial output register sout. Analog signal samples of the signal s are clocked into the parallel charge-coupled delay lines pch0 to pch7 in the form of charge packets under the control of the control means 8 at a comparatively high speed, and clocked out through the output register sout at a relatively low speed, *i.e.* time conversion takes place. The sampling circuit 12 is designed for converting voltage into charge at the input side and to convert charge into voltage at the output side out. According to the invention, inputs of the parallel charge-coupled delay lines pch0 to pch7 are coupled to outputs of a branched-off analog delay line d1, to an input of which the signal s1 is fed, *via* a charge demultiplexer dmx operating on the basis of charge packages and *via* input sections is0 to is7. The retiming of the input signal obtained in this manner achieves that less stringent requirements are imposed on the peripheral CCD clock system and driver system as described in US Patent 4,725,748 for a so-called serial-parallel-serial structure, while furthermore it can be ensured with a suitably chosen control of the charge demultiplexer dmx that the system of parallel delay lines is always optimally filled at different time base settings. Demultiplexing in the charge domain cannot only be effected very fast but is also easy to control, because charge can be easily manipulated through the application of external voltages to control gates. In this manner, a low-cost system may be made in which a high, switchable, sampling frequency is coupled to a constant acquisition record length.

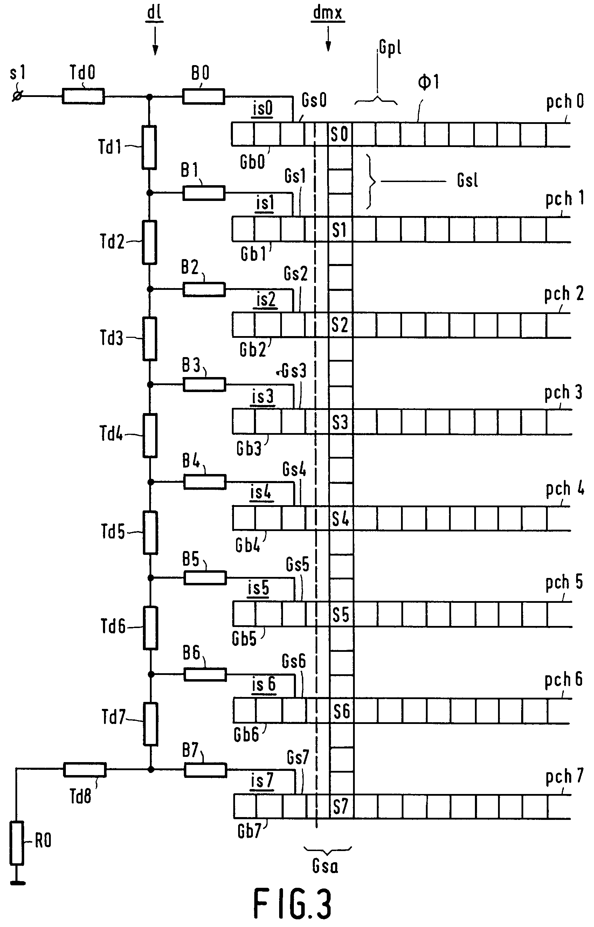

Fig. 3 shows in more detail a sampling device 12 according to the invention in which elements corresponding to those in Fig. 2 have been identified in the same manner. The branched-off analog delay line d1 comprises a number of delay elements Td1 to Td7 which show a delay of 1 nsec at a maximum desired sampling speed of 1 Gs/s. The analog delay line d1 further comprises two delay elements Td0 and Td1 at the input and output side thereof, respectively, each having a delay of 0,5 nsec, and a output resistor R0 at the output side thereof which is to minimize discrepancies between output signals of the analog delay line which are the result of reflections in branch-off points owing to capacitive loading of the branch-off points. The branch-off points on the delay line d1 are connected to sampling gates Gs0 to Gs7 of the input sections is0 to is7 *via* respective delay line buffers B0 to B7. The CCD input sections is0 to is7 further comprise blocking gates Gb0 to Gb7 for blocking or releasing ("disable"/"enable") input sections independently of one another. The conversion of voltage into charge also takes place in the input sections in a manner usual for CCD lines. The charge demultiplexer dmx consists of a chain of charge cells which are coupled to the input sections is0 to is7 and furthermore to inputs of the parallel charge-coupled delay lines pch0 to pch7. Sampling gates Gsa ensure that charge packets which are not blocked can be transported further at desired moments. At each intersection of the charge demultiplexer dmx and an input of parallel charge-coupled delay lines, control gates Gp1 ad Gs1 ensure that respective charge packets formed in input sections are passed on to a parallel delay line, or are first deflected *via* the charge demultiplexer dmx in order to go to a different parallel section. Passing on or deflecting of charge packets may be realised with cells in a two-layer polysilicon process. If the device is realised in a two-layer polysilicon process, a internal potential barrier can be built up for charge packets, and the internal potential barrier can be reduced by an external voltage in order to allow a charge packet to pass. In a three-layer polysilicon process it is not necessary to use internal potential barriers. This is because there are sufficient possibilities then for controlling the gates with external voltages. When a sampling cycle has been concluded in a given time base setting, the samplings of this cycle are clocked into the parallel delay lines pch0 to pch7 in synchronity with a clock φ1. Synchronous operation has the advantage that a simple CCD control logic and CCD control circuits can suffice, as well as fewer pins on CCD ICs. According to the invention, a two-dimensional charge storage structure is obtained in this way. An optimal filling of the CCD array may be obtained for every time base setting through a suitable control of the sampling device 12.

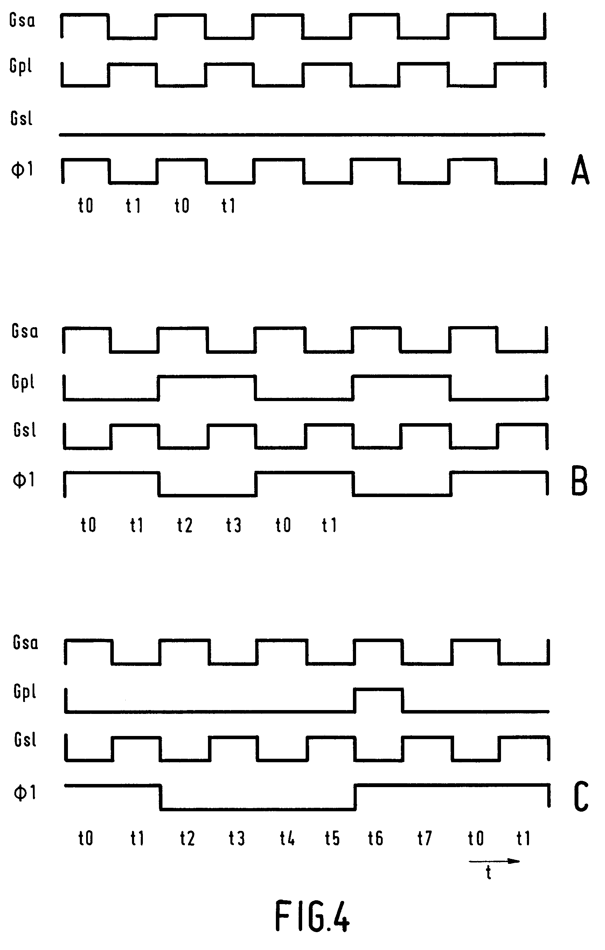

Figs. 4A, 4B and 4C show various clock signals Gsa, Gp1, Gs1 and φ1 as a function of time t in sampling device 12 according to the invention for optimal control of the two-dimensional structure shown in Fig. 3 for charge storage according to the invention, at various time base settings of the digital measuring instrument 1. The Table below contains various time base settings in nsec/division, with the sampling interval, blocked input sections, frequency Gsa, and synchronous clock φ1.

| time base setting (nsec/division) | sampling interval (nsec) | blocked input sections | frequency Gsa (MHz) | synchro-nous clock φ1 (MHz) |
|---|---|---|---|---|
| 50 | 1 | none | 125 | 125 |
| 100 | 2 | is1, is3, is5 and is7 | 125 | 62,5 |
| 200 | 4 | is1 to is3 and is5 to is7 | 125 | 31,25 |
| 500 | 10 | is1, is3, is5 and is7 | 25 | 12,5 |
| 1000 | 20 | is1 to is3 and is5 to is7 | 25 | 6,25 |
| 2000 | 40 | is1 to is7 | 25 | 3,125 |
| 5000 | 100 | is1 to is3 and is5 to is7 | 5 | 1,25 |
| 10.000 | 200 | is1 to is7 | 5 | 0,625 |
| 20.000 | 400 | is1 to is7 | 2,5 | 0,3125 |

Fig. 4A shows the clock signals for a time base setting of 50 nsec/division Fig. 4B for 100 nsec/division ad Fig. 4C for 200 nsec/division. It is assumed that there are 50 samples taken per division each time.

At the highest time base setting of 50 nsec/division belonging to Fig. 4A, the charge packets are directly passed on to corresponding parallel sections, *i.e.* with the 125 MHz clock Gsa and a clock signal Gp1 in counter phase eight charge packets become available for further transport in the parallel charge-coupled delay lines pch0 to pch7 in a single-stroke cycle on the synchronous clock φ1. There are eight charge packets ready below the sampling gate Gsa at t = t0 with a continuous numbering of charge packets S0 to S7, as shown in Fig. 3, and at t = t1 the eight charge packages are below the gates Gp1 ready for further transport. One charging cycle t0, t1 lasts 8 nsec, which corresponds to 125 MHz, and the effective clock frequency then is 1 GHz. Since the signal Gs1 is low, no charge packets can go through the charge demultiplexer dmx to parallel sections other than the corresponding ones. In the 50 nsec/division time base setting, accordingly, the charge packets Sn, Sn+1, ..., Sn+7, with n = 0, 1, ... enter respective parallel sections pch0, pch1, ..., pch7.

In the time base setting of 100 nsec/division belonging to Fig. 4B, the input sections is1, is2, is5 and is7 are blocked, so that charge packages can only come from the input sections is0, is2, is4 and is6. In a two-stroke cycle t = t0, t1 and t = t2, t3, the charge packages S0, S1, S2 and S3 are first brought to below the gates Gs1 in the charge demultiplexer dmx and then below the gates Gp1 of the parallel delay lines pch1, pch3, pch5 and pch7, while simultaneously the charge packages S4, S5, S6 and S7 are transported from the input sections is0, is2, is4 and is6 to below the gates Gp1 of the parallel delay lines pch0, pch2, pch4 and pch6. After the two-stroke cycle, the charge packages S4, S0, S5, S1, S6, S2, S7 and S3 are below the gates Gp1 of the parallel delay lines pch0, pch1, pch2, pch3, pch4, pch5, pch6 and pch7 ready for synchronous transport. In the 100 nsec/division time base setting, therefore, the charge packages Sn+4, Sn, Sn+5, Sn+1, Sn+6, Sn+2, Sn+7 and Sn+3 enter respective parallel sections pch0, pch1, ..., pch7. The parallel delay lines pch0 to pch7 are optimally filled in this manner.

In the time base setting of 200 nsec/division belonging to Fig. 4C, the input sections is1 to is3 and is5 to is7 are blocked, so that charge packages can only come from the input sections is0 and is4. In a four-stroke cycle t = t0, t1, t = t2, t3, t = t4, t5, and t = t6, t7, first the charge packets S0, S2, S4 and the charge packets S1, S3, S5 are parked in front of the respective parallel delay lines pch3, pch2, pch1, pch7, pch6 and pch5 through the input section is0 and the input section is4, respectively, through transport by the charge demultiplexer, and after that they are moved to below the gates Gp1 of the parallel delay lines pch0 to pch7 together with the charge packages S6 and S7, which are passed on from the respective input sections is0 and is4. In the 200 nsec/division time base setting, therefore, the charge packages Sn+6, Sn+4, Sn+2, Sn, Sn+7, Sn+5, Sn+3 and Sn+1 enter respective parallel sections pch0, pch1, ..., pch7. Here, too, the parallel delay lines pch0 to pch7 are optimally filled.

Direct conversion without time conversion can be used for the lower time base settings, *i.e.* up to 100 Ms/sec. Indirect conversion according to the invention can also be used for this, although the control of the sampling means becomes more complicated then because of the required sub-sampling. In the 500 nsec/division or 100 Ms/sec setting, the sampling distance must be 10 nsec. To achieve this, sub-sampling is necessary, *i.e.* samplings must be skipped. Skipping of a clock period means a time space of 8 nsec in the case of a 125 MHz clock. If a sample is taken in through the input section is0 and a sample is skipped at the input section is2, this will result in a sampling distance of 2 + 8 = 10 nsec (delay + clock pulse period). Correspondingly, samples are taken in through the input sections is4 and is6, while the input sections is1, is3, is5 and is7 are continually blocked. After eight charge packets have been taken in and have been intermediately stored in the charge demultiplexer dmx, they are synchronously clocked into the parallel charge-coupled delay lines pch0 to pch7.

The readout of the parallel charge-coupled delay lines may take place in usual manner. For this purpose, the serial output register sout is coupled to outputs of the parallel delay lines. At a control signal given by the control means 8, the parallel CCD lines will start running more slowly, for example at 125 kHz, and the serial output register sout is clocked with 1 MHz. In a final gate out of the serial output register sout, the charge packages are each converted into a voltage which is converted into a digital number by the analog-to-digital converter 10.

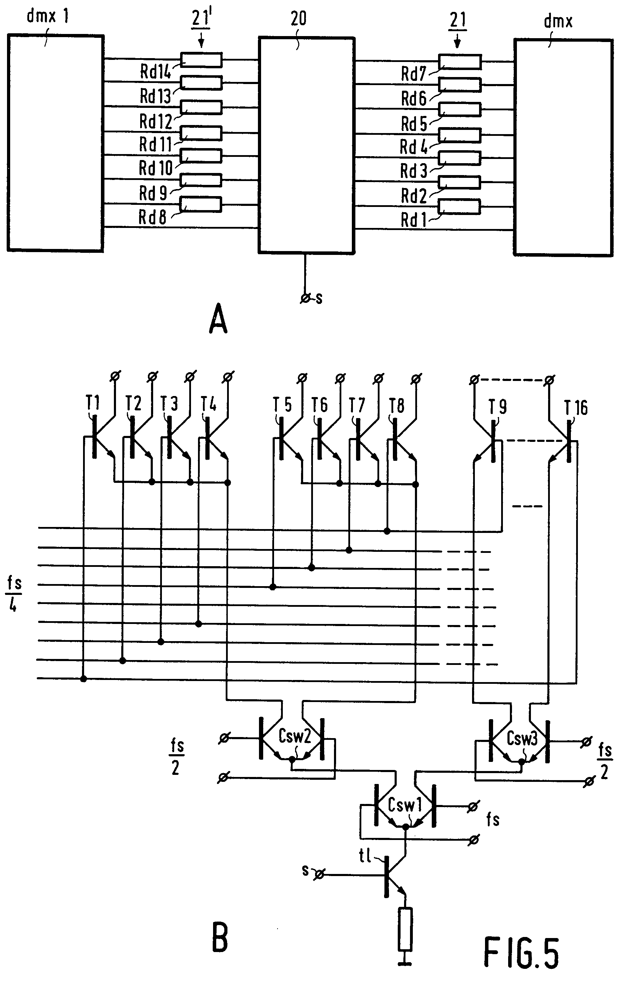

Fig. 5A diagrammatically shows a alternative embodiment of a portion of a sampling device 12 according to the invention in which sampling and current demultiplexing are combined with "retiming". The signal s1 is supplied to a signal demultiplexer 20 with eight outputs which are coupled to a retiming device 21 with delay lines Rd1, Rd2, Rd3, Rd4, Rd5, Rd6 and Rd7 which have different delays, *i.e.* delays of 1, 2, 3, 4, 5, 6 and 7 nsec, respectively. The eight outputs of the retiming device 21 are coupled to the charge demultiplexer dmx as shown in Fig. 2. For practical reasons, signal demultiplexing is performed in the interleaved mode, so that there are eight more outputs which are coupled to a similar charge demultiplexer through further delay lines Rd8 to Rd14. Interleaving may be omitted if the CCDs are fast enough. It is also possible to work with wider CCDs, such as a 16-channel CCDs. The signal demultiplexer 20 may form, for example, twice eight equidistant samplings of the input signal in the interleaved mode. A group of eight samples is stored in the parallel charge-coupled delay lines pch0 to pch7 through the charge demultiplexer dmx. Signal demultiplexing is obtained directly. The extra retiming is necessary for fully utilizing the charge demultiplexer and the storage facilities of the CCD array. Since the signal has already been sampled in the signal demultiplexer 20, this construction is less sensitive to discrepancies in the retiming device.

Fig. 5B shows in more detail the signal demultiplexer 20 operating in the interleaving mode. The signal demultiplexer 20 comprises a current switch Csw1, which switches with a sampling clock fs, to a tail t1 of which the analog signal (s) to be sampled is supplied after amplification or attenuation. Outputs of the current switch Csw1 are coupled to respective current switches Csw2 and Csw3 which are switched with fs/2. A further subdivision takes place through switching with fs/4, so that one of the switches T1, T2, ..., T16, which form current switches in pairs T1, T16; T2, T15; ..., T8, T9, pases current each time. Outputs of the switches T1 to T16 are coupled in groups of eight to the retiming device 21 and 21'. In this manner, both signal sampling ad signal demultiplexing are achieved with 1:16 demultiplexing.

The branched-off analog delay line described by way of example may be constructed in various ways, *i.e.* besides as a simple analog delay line also as delay lines used in combination with signal splitter devices, or in other ways. Furthermore, it can be determined through the measuring instrument whether data acquisition should be started at a trigger signal or should on the contrary be stopped then ("posttrigger mode" or "pretrigger mode").

## Claims

1. A sampling device (12) for sampling analog signals comprising an input for receiving an analog signal (s), a system of at least two parallel charge-coupled delay lines (pch0-pch7) coupled to the input for storage of signal samples of the analog signal, a output circuit (sout) coupled to the system of parallel delay lines (pch0-pch7) for the readout of the signal samples, and control means (8) for controlling charge transport through the system, the signal samples being stored in the form of charge packets, while the storage of the signal samples takes place at a substantially higher speed than the readout thereof, characterized in that the parallel delay lines (pch0-pch7) are coupled to one another at their input sides through a charge demultiplexer (dmx), and in that time-shifted replicas of the analog signal (s) are offered at input sections (is0-is7) of the parallel delay lines (pch0-pch7) through a signal demultiplexer (d1, 20).

2. A sampling device as claimed in Claim 1, characterized in that the signal demultiplexer is a branched-off analog delay line (d1) and signal sampling takes place in the input sections of the parallel delay lines (pch0-pch7).

3. A sampling device as claimed in Claim 1, characterized in that the signal demultiplexer is a network of current switches (20) in which time-shifted signal samples of the analog signal (s) are formed which are supplied to the charge demultiplexer (dmx, dmx1) through delay lines which are coupled to outputs of the network and which have different delays.

4. A sampling device as claimed in Claim 2 or 3, characterized in that all input sections (is0-is7) are enabled at a maximum sampling speed which can be selected, and the charge packets are clocked into the parallel delay lines synchronously after routing by the charge demultiplexer (dmx), and in that input sections (is0-is7) are disabled in the case of lower selected sampling speeds and the routing of the charge packets by the charge demultiplexer (dmx) is adapted in such a way that a equally optimum situation is obtained as with the maximum sampling speed.

5. A sampling device as claimed in any one of the preceding Claims, characterized in that the charge-coupled delay lines are made by the P²CCD technology.

6. A digital measuring instrument (1) provided with a sampling device (12) as claimed in any one of the preceding Claims and further provided with a trigger device (6) which provides a trigger signal in dependence on the analog input signal (s), characterized in that data acquisition is performed in dependence on the trigger signal in posttrigger or in pretrigger mode.

7. A digital measuring instrument as claimed in Claim 6, comprising a direct sampling circuit (9, 10, 11), characterized in that the measuring instrument comprises further control means (8) which control the sampling device (12) comprising the system of parallel delay lines (pch0-pch7) for sampling the analog signal in the case of a comparatively high sampling speed, and which control the direct sampling circuit (9, 10, 11) in the case of a comparatively low sampling speed.
